# EUROPÄISCHE PATENTSCHRIFT

(11) **EP 1 511 666 B1**
(45) Veröffentlichungstag und Bekanntmachung des Hinweises auf die Patenterteilung: **08.09.2010**
(21) Anmeldenummer: 03739365.9
(22) Anmeldetag: 27.02.2003
(51) Int. Cl.: H02P 29/02, H02H 7/08

(54) **ELEKTRONISCH KOMMUTIERBARER MOTOR**
ELECTRONICALLY COMMUTABLE MOTOR
MOTEUR A COMMUTATION ELECTRONIQUE

(30) Priorität: 24.05.2002 DE 10223139
(43) Veröffentlichungstag der Anmeldung: 09.03.2005
(73) Patentinhaber: ROBERT BOSCH GMBH, 70442 Stuttgart (DE)
(72) Erfinder: TOBIAS, Ralph, 76534 Baden-Baden (DE); BEYER, Stefan, 77815 Buehl (DE); SUTTER, Joerg, 76571 Gaggenau (DE); IMMENDOERFER, Ingo, 77815 Buehl (DE); FREY, Heiko, 76456 Kuppenheim (DE)
(86) Internationale Anmeldenummer: PCT/DE2003/000627
(87) Internationale Veröffentlichungsnummer: WO 2003/099632

(56) Entgegenhaltungen:
- EP-A- 0 340 044
- EP-A- 0 800 979
- US-A- 5 659 472
- US-B1- 6 194 849

## Beschreibung

### Stand der Technik

Die Erfindung betrifft einen elektronisch kommutierbaren Motor, wie er beispielsweise in der älteren DE-Patentanmeldung 100 644 86.4 beschrieben ist. Dort ist auch die elektronische Steuerung des Motors detailliert erörtert. Diese Ausführungen treffen auch auf den hier vorgeschlagenen elektronisch kommutierbaren Motor zu, weshalb auf Einzelheiten bei der Erläuterung der Motorsteuerung in der vorliegenden Anmeldung nicht nochmal im Detail eingegangen wird.

Das in der DE-Patentanmeldung 100 644 86.4 beschriebene Verfahren richtet sich speziell auf die Ermittlung der Rotorposition des Elektromotors, nicht auf besonders vorteilhafte, durch seine Bauweise und Ansteuerungsart ermöglichte Anwendungsformen. Diese sind Gegenstand der vorliegenden Anmeldung, welche sich auf die Verwendung des gattungsgemäßen Motors als Antriebsmotor für sicherheitskritische Nebenantriebe in Kraftfahrzeugen bezieht, insbesondere auf die Anwendung als Antriebsmotor einer elektrischen Lenkhilfe. Aufbau und Steuerung eines derartigen Motors erfüllen die Anforderungen an das Sicherheitskonzept der Antriebe, welches vorsieht, dass der Motor im Fehlerfall so beeinflusst werden kann, dass er kein die Sicherheit des Kraftfahrzeuges beeinträchtigendes Moment, insbesondere kein Bremsmoment bei der Betätigung der Lenkung eines Kraftfahrzeuges ausübt. Grund für die Verwendung des elektronisch kommutierbaren Motors ist bei der vorliegenden Erfindung daher auch nicht in erster Linie die verschleißfreie und wartungsarme Bauform aufgrund fehlender Schleifbürsten sondern neben der durch die Steuerung beeinflussbaren geringen Momentenwelligkeit besonders die Steuerungsmöglichkeit beim Auftreten eines Fehlers in einem Bauelement der Motorsteuerung oder im Motor selbst, insbesondere hinsichtlich eines Kurzschlusses in der Wicklung, wobei Kurzschlussströme auftreten, welche in der Größenordnung der Nennströme liegen und gefährliche Momente auf den Antrieb ausüben. Insbesondere können derartige Fehler dazu führen, dass beispielsweise bei einer elektrischen Lenkhilfe nicht nur die Lenkunterstützung ausfällt, sondern sogar ein Gegenmoment erzeugt wird, welches die Lenkbarkeit eines Fahrzeuges praktisch unmöglich macht.

Aus der US 6,194,849 B1 ist diesbezüglich ein elektrischer Lenkhilfeantrieb für ein Fahrzeug bekannt, der einen bürstenlosen Elektromotor aufweist, dessen drei an einem gemeinsamen Sternpunkt zusammen geschaltete Stränge der Erregerwicklung über eine Halbbrückenschaltung angesteuert werden. Um die Sicherheit des Lenkhilfeantriebs zu gewährleisten, ist im Fehlerfall mindestens einer der Stränge über ein zusätzliches Schaltmittel auftrennbar.

Weiterhin ist aus der EP 0 340 044 A2 ein elektrischer Lenkhilfeantrieb für ein Fahrzeug bekannt, bei dem die Stränge der Erregerwicklung des Elektromotors über eine Vollbrückenschaltung angesteuert werden, wobei eine Unterbrechung der Versorgung des Motors im Fehlerfall über einen zusätzlichen Unterbrecher erfolgt, der zwischen der Vollbrückenschaltung und einer Batterie des Fahrzeugs angeordnet ist.

Statt der Verwendung eines zusätzlichen Unterbrechers erfolgt das Sicherheitskonzept des in der EP 0 800 979 A2 gezeigten Elektromotors eines Lenkhilfeantriebs unmittelbar durch eine entsprechende Ansteuerung der pulsweitenmodulierten Halbleiterschalter einer den Motorstrang ansteuernden Vollbrückenschaltung. Ein vergleichbares Sicherheitskonzept in Verbindung mit einer Vollbrückenschaltung ist auch aus der US 5 659 472 bekannt.

Die Erfindung ist durch die Merkmale des Anspruchs 1 definiert Bevorzugte Ausgestaltungen sind in den abhängigen Ansprüchen definiert.

Eine im Sinne der Erfindung besonders zweckmäßige Ansteuerungsmöglichkeit für den Motor ergibt sich bei Verwendung einer Vollbrückenschaltung für die Kommutierungsanordnung, wobei die Stränge der Erregerwicklung einzeln an die Gleichspannungsquelle anschließbar sind. Durch die einzelne Ansteuerbarkeit der Stränge der Erregerwicklung kann in sehr vorteilhafter Weise ein Notlaufbetrieb sichergestellt werden, und zwar sowohl beim Auftreten eines Fehlers in der Kommutierungsanordnung als auch bei einem Fehler in einem Strang der Erregerwicklung. Ein Fehler in der Kommutierungseinrichtung oder in einem Strang der Wicklung führt auch hier zu einem Bremsmoment. Durch die Möglichkeit, einen einzelnen fehlerhaften Zweig der Kommutierungsanordnung unabhängig von den anderen Strängen mit Hilfe zusätzlicher Halbleiterschalter, vorzugsweise mittels MOSFET-Schalter, zu öffnen, kann bei einem Fehler in einem Halbleiterbauelement die Störgröße durch Öffnen des defekten Strangs abgeschaltet und der Betrieb des Motors mit 2/3 seiner Leistung fortgesetzt werden. Beim Auftreten eines Fehlers in einem Strang der Wicklung kann zwar ebenso wie bei der Sternschaltung der Wicklung die Störgröße nicht abgeschaltet werden, die Kompensation des entstehenden Bremsmomentes ist jedoch zu einem höheren Anteil als bei der Sternschaltung der Wicklung möglich, weil nur ein Strang betroffen ist.

Weitere Einzelheiten und vorteilhafte Weiterbildungen des erfindungsgemäßen Motors ergeben sich aus der folgenden Beschreibung dreier Ausführungsbeispiele und den zugehörigen Figuren.

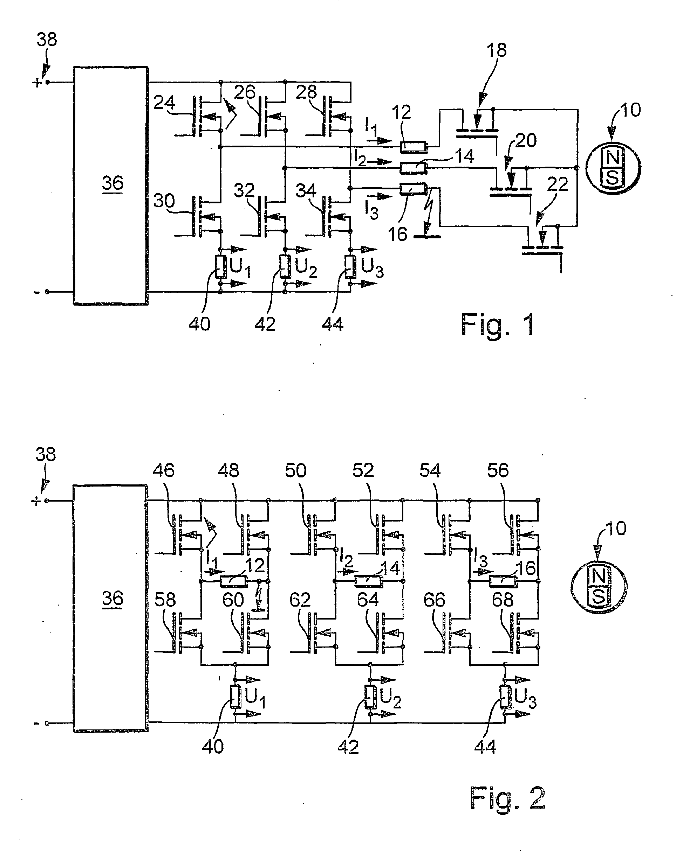

Diese zeigen in
Figur 1 eine mit Halbleiterschaltern bestückte Halbbrücken-Kommutierungsanordnung für die zu einem auftrennbaren Sternpunkt zusammengeschalteten Wicklungsstränge nach dem Stand der Technik und in Figur 2 eine ebenfalls aus dem Stand der Technik bekannte Schaltungsanordnung für einen elektronisch kommutierbaren Motor, dessen Wicklungsstränge einzeln über eine Vollbrücken-Kommutierungsanordnung mit einer Gleichspannungsquelle verbindbar sind.

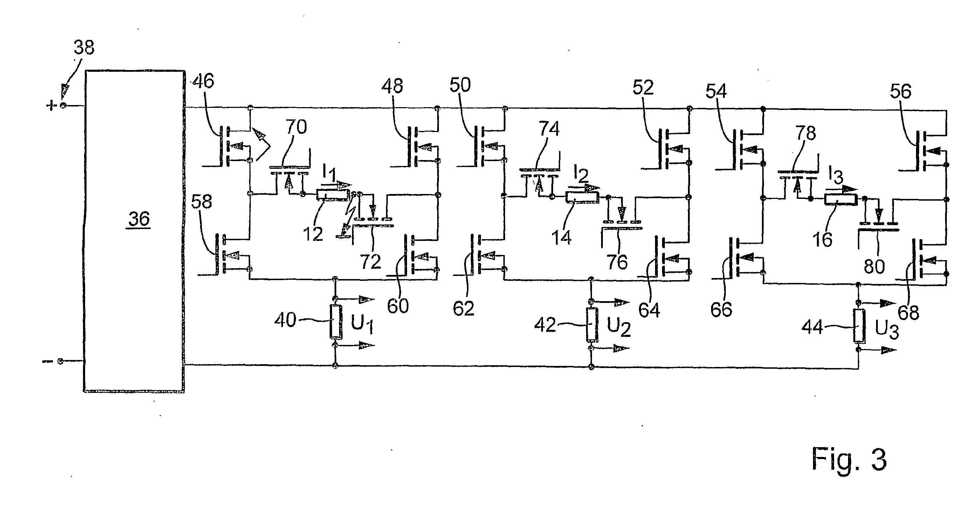

Figur 3 zeigt ein Ausführungsbeispiel einer erfindungsgemäßen Vollbrücken-Kommutierungsanordnung, bei der die Stränge der Erregerwicklung des Motors im Falle eines Windungsschlusses oder eines Fehlers in den Halbleiterschaltern der Kommutierungsanordnung über zusätzliche Halbleiterschalter abschaltbar sind.

### Ausführungsbeispiele

In Figur 1 ist mit 10 der mit Dauermagneten bestückte Rotor eines elektronisch kommutierbaren Motors bezeichnet, dessen dreisträngige Erregerwicklung im Stator angeordnet ist. Die Wicklungsstränge sind mit 12,14 und 16 bezeichnet und über MOSFET-Schalter 18,20,22 im Stern geschaltet. In den Wicklungssträngen 12,14 und 16 fließen die Phasenströme I₁, I₂, I₃, welche über eine sechspulsige Halbbrückenschaltung, auch B6-Schaltung genannt, gesteuert werden. Die Kommutierungsanordnung wird ebenfalls durch MOSFET-Schalter gebildet, welche die Bezugszeichen 24, 26, 28 beziehungsweise 30, 32, 34 tragen. Die Versorgungsspannungen und die Steuerbefehle erhalten die MOSFET-Schalter 24-34 der Kommutierungsanordnung ebenso wie die MOSFET-Schalter 18-22 der Sternpunktschaltung von einer Motorsteuerung 36, welche zwischen eine Gleichspannungsquelle 38 und die Eingänge der Kommutierungsanordnung geschaltet ist.

Der elektronisch kommutierbare Motor mit der Erregerwicklung im Stator und einem Permanentmagnete tragenden Rotor 10 wird auch als bürstenloser Gleichstrommotor (BLDC-Motor) bezeichnet. Ein derartiger Motor einschließlich seiner Steuerung ist in der eingangs bereits genannten DE- 100 644 86.4 bereits sehr ausfühlich erörtert und grundsätzlich auch bekannt. Auf die vollständige Wiederholung der Beschreibung des Aufbaus und der Ansteuerung des Motors soll daher in der vorliegenden Anmeldung verzichtet werden, erläutert werden lediglich die für seine Verwendung als Antriebsmotor eines sicherheitskritischen Nebenantriebes in einem Kraftfahrzeug, vorzugsweise als

Antriebsmotor einer elektrischen Fahrzeuglenkung, wesentlichen Bestandteile und Schaltungsmerkmale, also die Maßnahmen und Möglichkeiten zur Auftrennung bei Halbleiter- oder Wicklungsdefekten.

Bei der Schaltungsanordnung gemäß Figur 1 sind im ungestörten Betrieb die MOSFET-Schalter 18,20,22 geschlossen und bilden den Sternpunkt für die Wicklungsstränge 12,14,16. Die Größe und der Verlauf der Phasenströme I₁,I₂,I₃ wird über die MOSFET-Schalter 24,26,28 sowie 30,32 und 34 durch eine von der Motorsteuerung 36 ausgehende Pulsweitenmodulation geregelt. Hierbei wird der jeweilige Phasenstrom I₁,I₂,I₃ über den Sternpunkt und über drei Messwiderstände 40,42,44 zum Minuspol der Gleichspannungsquelle 38 geleitet.

Im ungestörten Betrieb des Motors sind die drei MOSFET-Schalter 18,20 und 22 geschlossen und definieren den Sternpunkt der Erregerwicklung. Die Phasenströme I₁, I₂, I₃ werden durch die Motorsteuerung 36 bestimmt, wobei zum Beispiel der Phasenstrom I₁ bei getaktetem MOSFET-Schalter 24 mit dem durch die Taktung vorgegebenen Verlauf über den leitenden MOSFET-Schalter 32 und den Widerstand 42 zurück zum negativen Pol der Gleichspannungsquelle gelangt. Der Freilaufstromkreis in den durch die Taktung bedingten Stromflusspausen schließt sich über die Wicklungsstränge 12 und 14 sowie die beiden MOSFET-Schalter 30 und 32. Der Schalter 32 ist in diesem Zeitraum leitend, beim MOSFET-Schalter 30 ergibt sich entweder ein passiver Freilauf über die integrierte Inversdiode oder ein aktiver Freilauf durch gepulstes Einschalten in den Stromschlusspausen des MOSFET Schalters 24. Entsprechend werden die Phasenströme I₂ und I₃ gesteuert.

Fehler beim Betrieb des Motors können insbesondere auftreten durch einen Fehler in einem der Halbleiterschalter der Kommutierungsanordnung oder durch einen Windungsschluss in einem der Wicklungsstränge. Beispielsweise bei einem Durchlegieren des MOSFET-Schalters 24 fließt aufgrund der durch die Drehung des Motors induzierten Spannungen in den Wicklungssträngen 12,14 und 16 ein Strom über die Inversdiode der MOSFET-Schalter 26 und 28 und erzeugt ein Bremsmoment, welches bei der Verwendung des Antriebes für eine elektrische Lenkhilfe in einem Kraftfahrzeug praktisch zur Unlenkbarkeit des Fahrzeuges führt. Hiergegen wird gemäß dem Stand der Technik Abhilfe geschaffen durch die Auftrennung des Sternpunktes der Wicklungsstränge 12,14,16 mittels des MOSFET-Schalters 18. Die Störgröße wird hierdurch abgeschaltet und der Antrieb bleibt funktionsfähig, wenn auch mit reduzierter Leistung. Beim Auftreten eines Windungsschlusses beispielsweise im Wicklungsstrang 16 entsteht ein Bremsmoment aufgrund der induzierten Spannung, wobei allerdings die Abschaltung der Störgröße durch die Auftrennung des Wicklungsternpunktes nicht möglich ist. Abhilfe wird in diesem Störfall jedoch dadurch geschaffen, dass durch die Auftrennung des Sternpunktes mit Hilfe der MOSFET-Schalter 18-22 zumindest ein Bremsmoment kompensiert werden kann, welches im Falle der Verwendung des Motors bei einer Kraftfahrzeug-Lenkhilfe der Lenkkraft des Fahrzeugführers entgegenwirken würde. Hierdurch bleibt die nicht unterstützte Lenkwirkung erhalten.

Die Anordnung in Figur 2 zeigt ebenfalls einen elektronisch kommutierbaren Motor mit dreisträngiger Erregerwicklung im Stator und permanentmagnetisch erregtem Rotor. Für gleiche Teile wie in Figur 1 sind daher gleiche Bezugszeichen verwendet. Abweichend von der Schaltungsanordnung in Figur 1 ist in Figur 2 eine Vollbrückenschaltung aus Halbleiterschaltern 46-68, auch 3H-Schaltung genannt, zur Kommutierung der Wicklungsstränge 12,14 und 16 vorgesehen. Hierdurch sind die Wicklungsstränge einzeln an die Gleichspannungsquelle 38 anschließbar und von ihr trennbar, wodurch sich noch weitergehende Möglichkeiten der Fehlerkompensation als bei der Schaltungsanordnung gemäß Figur 1 ergeben, bei welcher zur getrennten Steuerung der Wicklungsstränge drei, bei einer Vollbrückenschaltung grundsätzlich vorhandene, einzelne Treiber statt einem gemeinsamen B6-Brückentreiber erforderlich sind. Weiterhin können auch bei der Anordnung gemäß Figur 2 die Verluste aufgrund der Freilaufströme in den Kommutierungspausen durch einen aktiven Freilauf deutlich reduziert werden, wenn der Freilaufstrom über den jeweils zugeordneten, mit der Taktfrequenz eingeschalteten MOSFET-Schalter geführt wird. Beispielsweise müsste dann bei einem durch den MOSFET-Schalter 46 getakteten Strangstrom I₁ der MOSFET-Schalter 58 jeweils entsprechend der Taktfrequenz in den Stromflusspausen leitend geschaltet werden, sodass sich der Freilaufstrom des Wicklungsstrangs 12 über den in diesem Zeitintervall dauernd eingeschalteten MOSFET-Schalter 60 und den getaktet leitend geschalteten MOSFET-Schalter 58 ausgleichen kann. Die Taktung in den MOSFET-Schaltern kann analog zu der Taktung der MOSFET-Schalter in Figur 1 so gewählt, dass sich die gewünschte Stromform ergibt, um die Momentenwelligkeit zu minimieren.

Tritt bei der Schaltungsanordnung gemäß Figur 2 beispielsweise ein Fehler im MOSFET-Schalter 46 auf, durch welchen dieser dauernd leitend wird, dann fließt über diesen und den Wicklungsstrang 12 sowie die Inversdiode des MOSFET-Schalters 48 ein Strom, welcher in der Antriebsanordnung ein Bremsmoment bewirkt. Hier eröffnet die Vollbrückenschaltung nun die Möglichkeit, ohne Abschaltung der Störgröße das Bremsmoment zu kompensieren, sodass der Antrieb mit einem Teil seiner Leistung über die beiden ungestörten Wicklungsstränge 14 und 16 weiterbetrieben werden kann.

Besteht der aufgetretene Fehler in einem Windungsschluss, beispielsweise im Wicklungsstrang 12, so ist eine Abschaltung der Störgröße nicht möglich und es bildet sich ein Bremsmoment aus. Da jedoch nur ein Strang betroffen ist und die beiden anderen Stränge des Motors ungestört sind, kann das entstehende Bremsmoment durch die beiden intakten Wicklungsstränge kompensiert werden, derart, dass die nicht unterstützte Lenkwirkung erhalten bleibt.

Die erfindungsgemäße Anordnung in Figur 3 entspricht weitgehend derjenigen in Figur 2 und wird insoweit nicht nochmals beschrieben. Gleiche Teile in den Figuren 2 und 3 sind mit gleichen Bezugszeichen versehen. Abweichend von der Anordnung in Figur 2 sind jedoch die Wicklungsstränge 12, 14 und 16 hier nicht direkt in die Querzweige der Vollbrücken-Kommutierungsschaltung eingefügt, sondern beiderseits der Wicklungsstränge 12, 14 und 16 liegt jeweils ein zusätzlicher MOSFET-Schalter 70,72;74,76;78,80, wobei die beiden jedem Wicklungsstrang zusätzlich zugeordneten Halbleiterschalter jeweils mit entgegengesetzter Durchlassrichtung in den Querzweig eingefügt sind. Auf diese Weise besteht speziell bei der Verwendung von MOSFET-Halbleiterschaltern mit ihren integrierten Inversdioden die Möglichkeit der Auftrennung jedes einzelnen Brückenzweiges und somit der Abtrennung des zugehörigen Wicklungsstrangs. Diese Auftrennung ersetzt die Sternpunktauftrennung bei einer Anordnung entsprechend Figur 1.

Tritt bei der erfindungsgemäßen Schaltungsanordnung gemäß Figur 3 beispielsweise wiederum ein Fehler im MOSFET-Schalter 46 auf, durch welchen dieser dauernd leitend wird, so kann über den Wicklungsstrang 12 und die Inversdiode des MOSFET-Schalters 48 kein Fehlerstrom mehr fließen, weil dieser Stromkreis durch den zwischengeschalteten, nichtleitenden MOSFET-Schalter 70 unterbrochen ist. Entspechendes gilt beim Auftreten von Fehlern in den sonstigen MOSFET-Schaltern der Kommutierungsanordnung. Mit den zusätzlichen Maßnahmen gemäß der Schaltungsanordnung in Figur 3 eröffnet also die MOSFET-Vollbrückenschaltung nunmehr die Möglichkeit, die zusätzlichen Halbleiterschalter 70-80 in den Brückenquerzweigen zu öffnen und damit die Störgröße abzuschalten, sodass ein Bremsmoment erst gar nicht mehr auftreten kann und demzufolge eine höhere Leistung, beispielsweise für die Servolenkung eines Kraftfahrzeuges, zur Verfügung steht.

Besteht der aufgetretene Fehler in einem Windungsschluss, beispielsweise im Wicklungsstrang 12, so ist zwar eine Abschaltung der Störgröße durch das Öffnen der Halbleiterschalter 70 und 72 nicht möglich und es bildet sich ein Bremsmoment aus. Da die beiden anderen Stränge des Motors ungestört sind bleibt jedoch die nicht unterstützte Lenkwirkung erhalten.

Im erörterten Anwendungsfall als Antriebsmotor einer elektrischen Lenkhilfe in einem Kraftfahrzeug ist also sichergestellt, dass der Motor im Fehlerfall so beeinflusst werden kann, dass kein Bremmoment auf die Lenkung wirkt und zumindest der nicht durch eine Lenkhilfe unterstützte Lenkbetrieb gesichert ist. Andere Anwendungen von sicherheitskritischen Nebenantrieben in Kraftfahrzeugen sind beispielsweise die elektrische Bremse oder das elektrische Gaspedal, bei denen als Antriebsaggregat ebenfalls elektronisch kommutierbare Motoren mit Dauermagneten im Rotor vorteilhaft einsetzbar sind.

Die erfindungsgemäße Motorschaltung gemäß Figur 3 bietet somit die Möglichkeit, einen Fehlerstrom, welcher ein der vorgesehenen Antriebsrichtung entgegenwirkendes Moment erzeugt, abzuschalten. Die Vollbrückenschaltung bietet den besonderen Vorteil, dass sich jeder Strang separat ansteuern lässt, wodurch im Falle eines Fehlers in einer Endstufe das entstehende Bremsmoment über die beiden anderen Brückenzweige aufgehoben und ein Notlaufbetrieb ermöglicht werden kann. Ferner ist es bei der Vollbrückenschaltung auch möglich, einen Windungsschluss in einem Wicklungsstrang zu kompensieren. Ferner sind bei der Vollbrückenschaltung die Stromsignale dem entsprechenden Strang direkt zuordenbar, da jeder Strang separat gemessen wird, und die Kurvenform des Strangstromes kann ohne Mehraufwand für jeden Strang separat eingestellt werden, wodurch die Kompensationsmöglichkeit im Fehlerfall deutlich erhöht wird.

Bei den Ausführungsbeispielen ist die Kommutierungsanordnung jeweils unter Verwendung von MOSFET-Schaltern als Halbleiterbauelementen beschrieben. Derartige MOSFET-Schalter eignen sich wegen ihrer niedrigen Verlustleistung und hohen Störungssicherheit, aber auch wegen der unkritischen Versorgungsspannung und der guten Schaltungs-Integrierbarkeit neben der Verwendung bei der Kommutierungssteuerung auch besonders gut für die Auftrennung des Sternpunktes.

## Patentansprüche

1. Elektronisch kommutierbarer Motor für einen sicherheitskritischen Nebenantrieb in einem Kraftfahrzeug, mit einer dreisträngigen Erregerwicklung (12, 14, 16) im Stator, welche zur Erzeugung eines Drehmoments für einen Dauermagnet-Rotor (10) über eine mit Halbleiterschaltern (46, 48, 50, 52, 54, 56, 58, 60, 62, 64, 66, 68) bestückte Kommutierungsanordnung und eine Motorsteuerung (36) an eine Gleichspannungsquelle (38) anschließbar ist, wobei die Stränge (12, 14, 16) der Erregerwicklung über eine Vollbrückenschaltung aus den Halbleiterschaltern (46, 48, 50, 52, 54, 56, 58, 60, 62, 64, 66, 68) einzeln an die Gleichspannungsquelle (38) anschließbar sind, **gekennzeichnet durch** zusätzliche Halbleiterschalter (70, 72, 74, 76, 78, 80) zur Abschaltung der Stränge (12, 14, 16) der Erregerwicklung im Falle eines Windungsschlusses und/oder eines Fehlers in den Halbleiterschaltern (46, 48, 50, 52, 54, 56, 58, 60, 62, 64, 66, 68) der Kommutierungsanordnung, um ein vom Motor erzeugtes Bremsmoment zu unterbinden oder zumindest teilweise zu kompensieren.

2. Elektronisch kommutierbarer Motor nach Anspruch 1, **dadurch gekennzeichnet, dass** je zwei der zusätzlichen Halbleiterschalter (70, 72, 74, 76, 78, 80) mit entgegengesetzten Durchlassrichtungen in jedem Brückenzweig beidseitig jedes Stranges (12, 14, 16) der Erregerwicklung angeordnet sind.

3. Elektronisch kommutierbarer Motor nach einem der Ansprüche 1 oder 2, **dadurch gekennzeichnet, dass** die Halbleiterschalter (46, 48, 50, 52, 54, 56, 58, 60, 62, 64, 66, 68) der Kommutierungsanordnung und/oder die zusätzlichen Halbleiterschalter (70, 72, 74, 76, 78, 80) als MOSFET-Schalter ausgebildet sind.

4. Elektronisch kommutierbarer Motor nach Anspruch 1, **dadurch gekennzeichnet, dass** die Stränge (12, 14, 16) der Erregerwicklung und/oder die Brückenzweige der Kommutierungsanordnung pyrotechnisch auftrennbar sind.

5. Elektronisch kommutierbarer Motor nach Anspruch 1, **dadurch gekennzeichnet, dass** die Steuerung der durch die Stränge (12, 14, 16) der Erregerwicklung fließenden Strangströme (I₁, I₂, I₃) durch Pulsweitenmodulation erfolgt.

6. Elektronisch kommutierbarer Motor nach Anspruch 5, **dadurch gekennzeichnet, dass** in den Stromflusspausen der Strangströme (I₁, I₂, I₃) ein aktiver Freilauf durch gepulstes Einschalten eines weiteren Halbleiterschalters (58, 60, 62, 64, 66, 68) der Kommutierungsanordnung erzeugt wird.

7. Elektrische Lenkhilfe mit einem elektronisch kommutierbaren Motor nach einem der Ansprüche 1 bis 6.

## Claims

1. Electronically commutatable motor for a safety-critical auxiliary drive in a motor vehicle, having a three-phase field winding (12, 14, 16) in the stator, which field winding, in order to generate a torque for a permanent-magnet rotor (10), can be connected to a DC voltage source (38) via a commutation arrangement, which is fitted with semiconductor switches (46, 48, 50, 52, 54, 56, 58, 60, 62, 64, 66, 68), and a motor control system (36), wherein the phases (12, 14, 16) of the field winding can be individually connected to the DC voltage source (38) via a full-bridge circuit comprising the semiconductor switches (46, 48, 50, 52, 54, 56, 58, 60, 62, 64, 66, 68), **characterized by** additional semiconductor switches (70, 72, 74, 76, 78, 80) for disconnecting the phases (12, 14, 16) of the field winding in the case of a short between the turns and/or a fault in the semiconductor switches (46, 48, 50, 52, 54, 56, 58, 60, 62, 64, 66, 68) of the commutation arrangement, in order to suppress a braking torque which is generated by the motor or to at least partially compensate said braking torque.

2. Electronically commutatable motor according to Claim 1, **characterized in that** in each case two additional semiconductor switches (70, 72, 74, 76, 78, 80) with opposite conducting directions are arranged in each bridge arm on either side of each phase (12, 14, 16) of the field winding.

3. Electronically commutatable motor according to one of Claims 1 and 2, **characterized in that** the semiconductor switches (46, 48, 50, 52, 54, 56, 58, 60, 62, 64, 66, 68) of the commutation arrangement and/or the additional semiconductor switches (70, 72, 74, 76, 78, 80) are in the form of MOSFET switches.

4. Electronically commutatable motor according to Claim 1, **characterized in that** the phases (12, 14, 16) of the field winding and/or the bridge arms of the commutation arrangement can be pyrotechnically disconnected.

5. Electronically commutatable motor according to Claim 1, **characterized in that** the phase currents (I₁, I₂, I₃) flowing through the phases (12, 14, 16) of the field winding are controlled by pulse-width modulation.

6. Electronically commutatable motor according to Claim 5, **characterized in that** active freewheeling is generated in the current-flow pauses of the phase currents (I₁, I₂, I₃) by switching on a further semiconductor switch (58, 60, 62, 64, 66, 68) of the commutation arrangement in a pulsed manner.

7. Electrical steering aid having an electronically commutatable motor according to one of Claims 1 to 6.

## Revendications

1. Moteur à commutation électronique pour un entraînement auxiliaire essentiel à la sécurité dans un véhicule automobile, comprenant un enroulement excitateur (12, 14, 16) à trois faisceaux dans le stator, lequel peut être raccordé à une source de tension continue (38) par le biais d'un arrangement de commutation équipé de commutateurs à semiconducteur (46, 48, 50, 52, 54, 56, 58, 60, 62, 64, 66, 68) et d'une commande de moteur (36) en vue de générer un couple pour un rotor à aimant permanent (10), les faisceaux (12, 14, 16) de l'enroulement excitateur pouvant être raccordés individuellement à la source de tension continue (38) par le biais d'un circuit en pont intégral constitué des commutateurs à semiconducteur (46, 48, 50, 52, 54, 56, 58, 60, 62, 64, 66, 68), **caractérisé par** des commutateurs à semiconducteur supplémentaires (70, 72, 74, 76, 78, 80) pour mettre hors circuit les faisceaux (12, 14, 16) de l'enroulement excitateur dans le cas d'un court-circuit d'enroulement et/ou d'un défaut dans les commutateurs à semiconducteur (46, 48, 50, 52, 54, 56, 58, 60, 62, 64, 66, 68) de l'arrangement de commutation afin d'inhiber ou de compenser au moins partiellement un moment de freinage produit par le moteur.

2. Moteur à commutation électronique selon la revendication 1, **caractérisé en ce que** deux des commutateurs à semiconducteur supplémentaires (70, 72, 74, 76, 78, 80) avec des sens de passage opposés sont à chaque fois disposés dans chaque branche du pont des deux côtés de chaque faisceau (12, 14, 16) de l'enroulement excitateur.

3. Moteur à commutation électronique selon l'une des revendications 1 ou 2, **caractérisé en ce que** les commutateurs à semiconducteur (46, 48, 50, 52, 54, 56, 58, 60, 62, 64, 66, 68) de l'arrangement de commutation et/ou les commutateurs à semiconducteur supplémentaires (70, 72, 74, 76, 78, 80) sont réalisés sous la forme de commutateurs MOSFET.

4. Moteur à commutation électronique selon la revendication 1, **caractérisé en ce que** les faisceaux (12, 14, 16) de l'enroulement excitateur et/ou les branches de pont de l'arrangement de commutation peuvent être déconnectés de manière pyrotechnique.

5. Moteur à commutation électronique selon la revendication 1, **caractérisé en ce que** la commande des courants de faisceau (I₁, I₂, I₃) qui circulent à travers les faisceaux (12, 14, 16) de l'enroulement d'excitation s'effectue par modulation d'impulsion en largeur.

6. Moteur à commutation électronique selon la revendication 5, **caractérisé en ce qu'**un régime libre actif est produit pendant les pauses d'impulsion des courants de faisceau (I₁, I₂, I₃) par mise en circuit impulsionnelle d'un commutateur à semiconducteur (58, 60, 62, 64, 66, 68) supplémentaire de l'arrangement de commutation.

7. Assistance à la direction électrique comprenant un moteur à commutation électronique selon l'une des revendications 1 à 6.
